# EUROPÄISCHE PATENTSCHRIFT

(11) **EP 0 542 793 B1**
(45) Veröffentlichungstag und Bekanntmachung des Hinweises auf die Patenterteilung: **30.11.1994**
(21) Anmeldenummer: 91913805.7
(22) Anmeldetag: 26.07.1991
(51) Int. Cl.: H01L 21/00

(54) **ANORDNUNG ZUM LAGERN, TRANSPORTIEREN UND EINSCHLEUSEN VON SUBSTRATEN**
ARRANGEMENT FOR STORING, TRANSPORTING AND ENCLOSING SUBSTRATES
AGENCEMENT POUR LE STOCKAGE, LE TRANSPORT ET LE TRANSFERT EN SALLE BLANCHE DE SUBSTRATS

(30) Priorität: 07.08.1990 DE 4024973
(43) Veröffentlichungstag der Anmeldung: 26.05.1993
(73) Patentinhaber: International Business Machines Corporation, Armonk, N.Y. 10504 (US)
(72) Erfinder: BÖHMER, Gudrun, D-7000 Stuttgart 80 (DE); GENTISCHER, Josef, D-7064 Remshalden (DE); LEHNER, Rolf, D-7300 Esslingen 1 (DE); MODJESCH, Dieter, D-7045 Nufringen (DE); SCHMUTZ, Wolfgang, D-7214 Zimmern 1 (DE)
(74) Vertreter: Schäfer, Wolfgang, Dipl.-Ing.
(86) Internationale Anmeldenummer: EP9101406
(87) Internationale Veröffentlichungsnummer: WO9202950

(56) Entgegenhaltungen:
- FR-A- 2 615 174
- US-A- 4 699 555
- US-A- 4 758 127

## Beschreibung

Die Erfindung betrifft eine Anordnung zum Lagern und Transportieren von Substraten unter Reinraumbedingungen und zum Einschleusen der Substrate in einen Reinraum gemäß dem Oberbegriff des Anspruches 1.

Bei der Behandlung von Substraten insbesondere in der Halbleiter-Fertigung ist es bekannt, eine größere Anzahl von z.B. fünfundzwanzig Substraten in einem Substratträger (Carrier) anzuordnen, der zum Lagern und Transportieren in einer Reinraumbox eingeschlossen wird. Eine solche Anordnung ist beispielsweise beschrieben in der EP-A-0 151 336.

Über eine Schleuse kann der Substratträger aus der Reinraumbox durch eine entsprechende Öffnung im Boxenboden hindurch in einen Reinraum eingeschleust werden, in welchem die Substrate aufeinanderfolgend aus dem Substratträger entnommen und behandelt werden. Die behandelten Substrate werden wieder in den Substratträger eingesetzt und nach Abarbeiten sämtlicher Substrate des Substratträgers wird dieser wieder über die Schleuse in die Reinraumbox zurückgeführt.

Dieses sogenannte SMIF-Konzept (Standard Mechanical Interface) erlaubt ein Lagern der Substrate unter Reinraumbedingungen und ein weitgehend automatisches Zuführen, Einschleusen und Bearbeiten der Substrate unter Reinraumbedingungen. Das SMIF-Konzept ist jedoch nur für die Behandlung größerer Lose wirtschaftlich. Bei kleinen Losgrößen bis herab zur Losgröße 1 ergibt sich eine starke Unterbelegung der Substratträger und der Reinraumboxen, was zu einem unvertretbaren Aufwand beim automatischen Einschleusen in den Reinraum führt und zuviel Lagerraum beansprucht.

Werden Substrate, wie z.B. Wafer, Mehrschichtkeramiksubstrate oder Belichtungsmasken, in kleinen Losgrößen behandelt, so ist es deshalb üblich, die Substrate in jeweils nur ein einzelnes Substrat aufnehmenden verschließbaren Kassetten zu lagern. Zur Behandlung werden die Substrate von Hand aus diesen Kassetten entnommen, vor Ort in der gewünschten Anzahl zu Horden zusammengestellt und in offene Vielfach-Substratträger eingelegt. Diese Substratträger werden oftmals von Hand in den Reinraum eingeschleust und die Substrate werden dort durch automatische Greifer zur Behandlung entnommen und wieder in den Substratträger zurückgeführt. Nach Abarbeiten der Horde werden die Substrate wiederum von Hand zur Lagerung in die Kassetten zurückgeführt. Das häufige Umsetzen der Substrate von Hand führt zu einer erheblichen Partikelkontamination der Substrate durch Reibung und Berührung.

Eine automatische Manipulatoranordnung für einzelne Substrate ist beschrieben in der DE-A-37 16 549. Bei dieser Anordnung werden die Substrate in einzelnen Fächern eines Magazins aufbewahrt, welches höhenverstellbar an einem Manipulator vorbeigeführt wird. Die Beladung der Fächer kann durch einen verschließbaren Schlitz in einer Reinraumwand erfolgen.

Der Erfindung liegt die Aufgabe zugrunde, eine Anordnung zur Verfügung zu stellen, mit welcher Substrate in kleinen Losgrößen und in variabler Anzahl unter Reinraumbedingungen gelagert, transportiert und automatisch zur Behandlung in einen Reinraum eingeschleust werden können.

Diese Aufgabe wird bei einer Anordnung der eingangs genannten Gattung erfindungsgemäß gelöst durch die Merkmale des kennzeichnenden Teiles des Anspruches 1.

Vorteilhafte Ausführungsformen der Erfindung sind in den Unteransprüchen angegeben.

Bei der erfindungsgemäßen Anordnung sind die Substrate einzeln in verschließbaren Kassetten untergebracht. Die Kassetten weisen an einer Seitenwand eine Verschlußklappe auf und können mit dieser Seitenwand an einem Beladeschlitz angeordnet werden, der in der äußeren Trennwand des Reinraumes vorgesehen ist. Das Substrat ist in der Kassette in einer Substratschublade aufgenommen, die nach Öffnen der Verschlußklappe durch den Beladeschlitz in den Reinraum ausgefahren wird, so daß das Substrat durch einen Greifer erfaßt, entnommen und der Behandlung zugeführt werden kann. Nach der Behandlung wird das Substrat in umgekehrter Reihenfolge wieder in die Substratschublade eingesetzt, diese wird in die Kassette zurückgefahren, worauf die Kassette mittels der Verschlußklappe wieder dicht verschlossen wird.

Das Substrat kann in der Kassette unter Reinraumbedingungen gelagert und transportiert werden. Das Ein- und Ausschleusen des Substrates aus der Kassette in den Reinraum und zurück erfolgt automatisch und ebenfalls unter Reinraumbedingungen, so daß eine Kontaminierung des Substrates praktisch ausgeschlossen ist.

Da die Substrate jeweils einzeln in Kassetten angeordnet sind, ist eine optimale Anpassung des Lagerplatzbedarfes an die jeweils erforderliche Losgröße möglich. Ebenso kann der Transport und das automatische Einschleusen der Substrate flexibel und ohne Fehlzeiten der jeweils aktuellen Losgröße angepaßt werden.

Bei kleinen Losgrößen und zeitaufwendigen Behandlungsprozessen kann es ausreichend und wirtschaftlich sein, die Kassetten von Hand einzeln dem Lager zu entnehmen und an dem Beladeschlitz des Reinraumes anzuordnen. Wenn die Losgrößen anwachsen und eine stärkere Automation gewünscht ist, ist es zweckmäßig, die Kassetten auf einem Hubwerk zu stapeln, das außerhalb der Trennwand angrenzend an den Beladeschlitz angeordnet ist und die Kassetten taktweise aufeinanderfolgend mit ihrer Verschlußklappe an den Beladeschlitz bringt. Die Kassetten können dabei unmittelbar auf dem Hubwerk gestapelt werden, insbesondere wenn nur eine kleine Zahl von Kassetten zu bearbeiten ist und sich das Kassettenlager in unmittelbarer Nähe des Beladeschlitzes befindet. Bei größerer Kassettenanzahl und bei einer größeren Entfernung von Kassettenlager und Beladeschlitz ist es häufig zweckmäßig, einen Kassettenträger vorzusehen, in dem die Kassetten gestapelt werden und der auf das Hubwerk aufsetzbar ist.

Um das Ein- und Ausschleusen des Substrates unter Reinraumbedingungen zu halten, ist der Beladeschlitz vorzugsweise mit nach außen gegen die Kassette vorspringenden Randlippen ausgestattet. In der Einschleus-Position schließt die Kassette mit ihrer Seitenwand an diese Randlippen an und die Verschlußklappe öffnet sich schwenkend in die Randlippen und liegt in ihrer Offenstellung auf der Innenfläche einer Randlippe auf. Eventuell an der Außenseite der Verschlußklappe anhaftende Kontamination, z.B. Partikel, Verunreinigungen, Kondensat, wird auf diese Weise sandwichartig zwischen der Verschlußklappe und der Randlippe eingeschlossen und kann nicht mit dem Substrat in Berührung kommen. Die in dem Reinraum unter Überdruck stehende Reinluft strömt durch den Beladeschlitz und die Berührungsfugen zwischen den Randlippen und der Kassette aus und verhindert ein Eindringen von kontaminierenden Partikeln während des Ein- und Ausschleusens.

Das Aus- und Einfahren der Substratschublade wird vorzugs weise über Antriebsglieder bewirkt, die in der Kassette angeordnet sind und durch innere Trennwände gegen den das Substrat aufnehmenden Raum abgetrennt sind. Dadurch wird vermieden, daß Abriebspartikel der Antriebsglieder das Substrat kontaminieren. Die Antriebsglieder können berührungslos, z.B. magnetisch, durch die geschlossene Kassettenwand betätigt werden. Da die Antriebsglieder durch die innere Trennwand gegen das Substrat abgeschottet sind, ist es auch möglich, den Antriebsmechanismus über einen Führungsschlitz in der Kassettenwand zu betätigen.

Um das Substrat in der Kassette gegen Beschädigung sicher zu lagern, wird das von der Substratschublade aufgenommene Substrat vorzugsweise zwischen der geschlossenen Verschlußklappe und der gegenüberliegenden Seitenwand der Kassette festgelegt. Zusätzlich kann das Substrat noch durch innen an der Kassettenoberseite angeordnete Federn auf der Substratschublade festgehalten werden.

Die Aufnahme der einzelnen Substrate in jeweils gesonderten Kassetten ermöglicht eine besonders flexible Organisation der Lagerung, des Transportes und der Behandlung der Substrate. Die Kassetten können mit einer automatisch lesbaren Kennzeichnung versehen sein, durch welche der Transport, die Behandlung im Reinraum und die Lagerung gesteuert werden. In diesem Fall ist das jeweilige Substrat stets eindeutig einer Kassette zugeordnet. Das Substrat wird dementsprechend nach der Behandlung wieder in dieselbe Kassette zurückgeführt, aus welcher es entnommen wurde. In einer anderen Ausführung kann die Kassette ein Fenster aufweisen, durch welches eine automatisch lesbare Kennzeichnung des Substrates selbst optisch abgetastet werden kann. In diesem Fall ist eine Zuordnung von Substrat und Kassette nicht notwendig. Das Substrat kann aus einer Kassette entnommen und nach der Behandlung in eine andere Kassette eingesetzt werden. Dies kann z.B. bei einer entsprechenden Ausbildung der Handlingsvorrichtung in dem Reinraum zu einem günstigeren Materialfluß führen. Außerdem ist eine universellere Verwendbarkeit der Kassetten möglich.

Im folgenden wird die Erfindung anhand von in der Zeichnung dargestellten Ausführungsbeispielen näher erläutert. Es zeigen :
- Figur 1: eine teilweise geschnittene schematische Seitenansicht der Anordnung in der Beladeposition des Hubwerkes,;
- Figur 2: eine entsprechende Seitenansicht in der Einschleusposition;
- Figur 3a: perspektivisch einen Kassettenträger;
- Figur 3b: perspektivisch den Kassettenträger mit eingesetzten Kassetten,;
- Figur 4: in einem Horizontalschnitt eine Draufsicht auf die Trageplatte des Hubwerkes mit dem leeren Kassettenträger;
- Figur 5: perspektivisch die Unterseite einer Kassette mit der der Verschlußklappe entgegengesetzten Seitenwand;
- Figur 6: perspektivisch die Oberseite der Kassette mit der die Verschlußklappe aufweisenden Seitenwand;
- Figur 7a: eine Seitenansicht der Kassette in einer ersten Ausführungsform mit geöffneter Verschlußklappe;
- Figur 7b: einen Horizontalschnitt durch die Kassette der Figur 7a,;
- Figur 8a: eine Seitenansicht der Kassette in einer zweiten Ausführungsform mit geöffneter Verschlußklappe;
- Figur 8b: einen Horizontalschnitt durch die Kassette der Figur 8a;
- Figur 9a: einen Vertikalschnitt durch die Kassette mit geschlossener Verschlußklappe; und
- Figur 9b: einen Figur 9a entsprechenden Vertikalschnitt mit geöffneter Verschlußklappe.

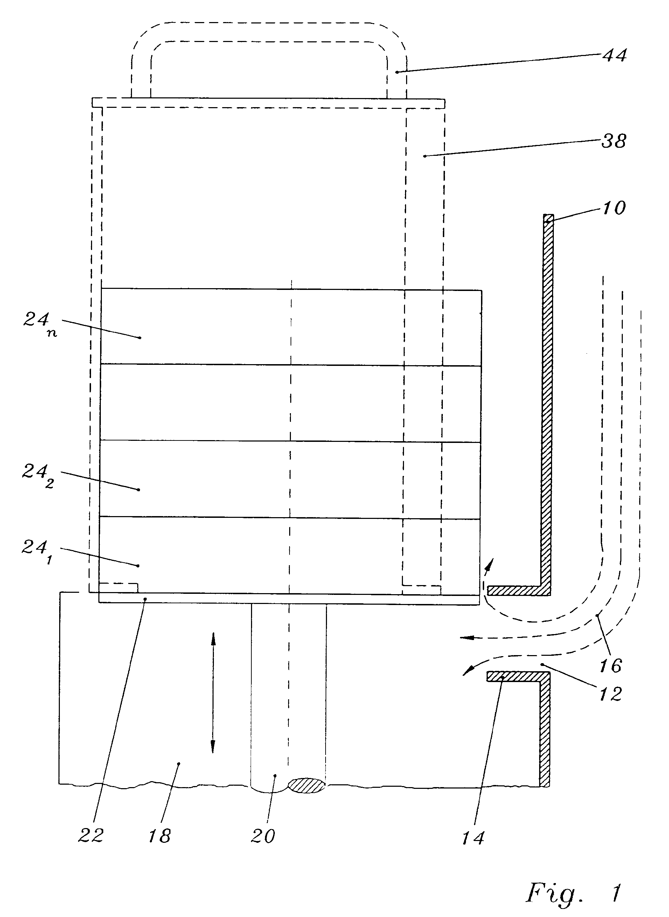

In Figur 1 ist mit 10 die äußere Trennwand eines Reinraumes bezeichnet, in welchem sich nicht dargestellte Vorrichtungen zum Behandeln von Substraten sowie Handlingseinrichtungen für die Substrate befinden. Die Behandlungsvorrichtungen und die Handlingseinrichtungen können in beliebiger bekannter Weise ausgebildet sein. Die Trennwand 10 ist von einem Beladeschlitz 12 durchbrochen, der von ringsumlaufenden nach außen vorspringenden Randlippen 14 umschlossen ist. Dem Reinraum wird in bekannter Weise Reinluft mit Überdruck zugeführt, so daß durch den Beladeschlitz 12 kontinuierlich ein laminarer Strom 16 von Reinluft austritt und keine Staubpartikel durch den Beladeschlitz 12 in den Reinraum eindringen können.

Außerhalb der Trennwand 10 ist ein Hubwerk 18 vorgesehen, das eine vertikale Hubsäule 20 mit einer horizontalen Hubplatte 22 aufweist. Die Hubsäule 20 ist z.B. mittels eines Schrittmotors steuerbar getaktet antreibbar, um die Hubplatte 22 an dem Beladeschlitz 12 vorbeizubewegen und an diesem zu positionieren. Das Hubwerk 18 ist insgesamt durch ein Gehäuse gekapselt, dessen obere Abdeckung mit der oberen Randlippe 14 des Beladeschlitzes 12 bündig ist. Der durch den Beladeschlitz 12 austretende Reinluftstrom 16 durchspült daher das Gehäuse des Hubwerkes 18 und hält im Hubwerk 18 entstehende Schmutzpartikel von dem Beladeschlitz 12 fern.

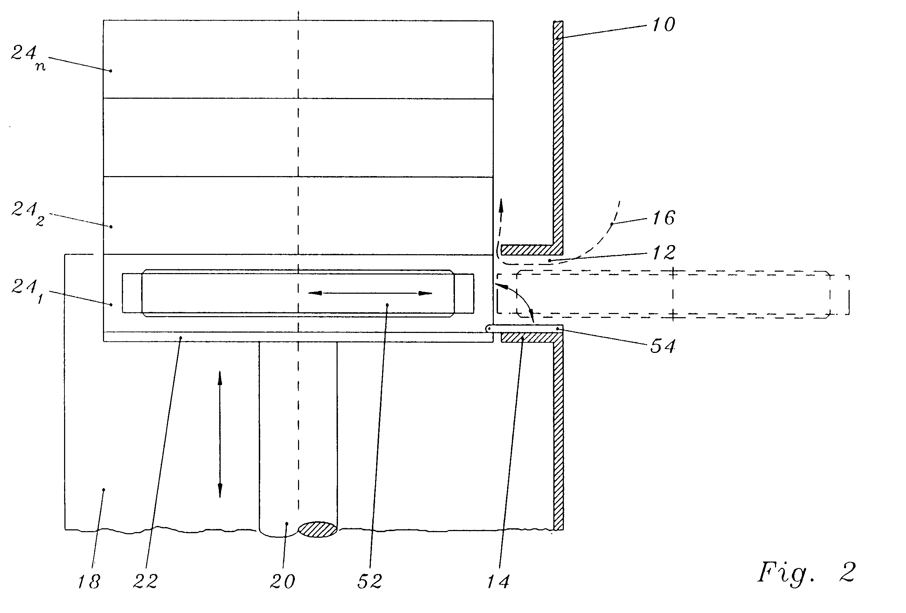

Auf der Hubplatte 22 können mehrere Kassetten 24₁ bis 24ₙ gestapelt werden. Zum Aufsetzen der Kassetten 24 wird die Hubplatte 22 in eine in Figur 1 dargestellte angehobene Beladeposition gefahren, in welcher sich die Hubplatte 22 oberhalb des Beladeschlitzes 12 und dem Gehäuse des Hubwerkes 18 befindet. Die Hubplatte 22 wird dann schrittweise abgesenkt, wobei die Kassetten 24₁ bis 24ₙ nacheinander oder in einer automatisch anwählbaren Reihenfolge mit einer Seitenfläche an die Randlippen 14 des Beladeschlitzes anschließend positioniert werden, wie dies in Figur 2 für die unterste Kassette 24₁ dargestellt ist.

In dem dargestellten Ausführungsbeispiel ist das Hubwerk 18 vertikal verfahrbar, die Hubplatte 22 ist horizontal angeordnet und die horizontal auf der Hubplatte 22 gestapelten Kassetten 24₁ bis 24ₙ werden vor dem horizontal angeordneten Beladeschlitz 12 positioniert. Es ist ohne weiteres ersichtlich, daß das Hubwerk auch horizontal verfahrbar ausgebildet sein kann, wobei dann die Kassetten horizontal nacheinander an dem Beladeschlitz vorbeigefahren und positioniert werden.

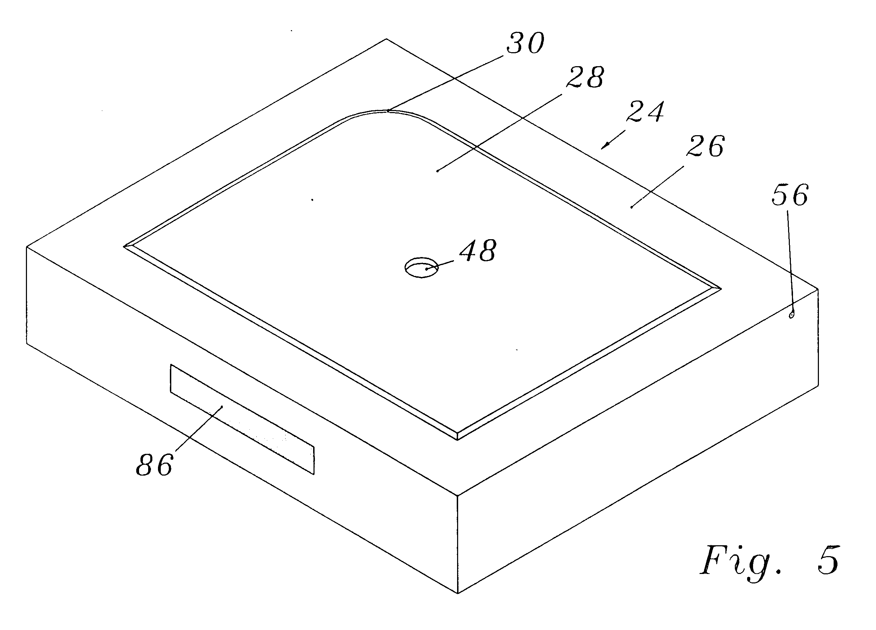

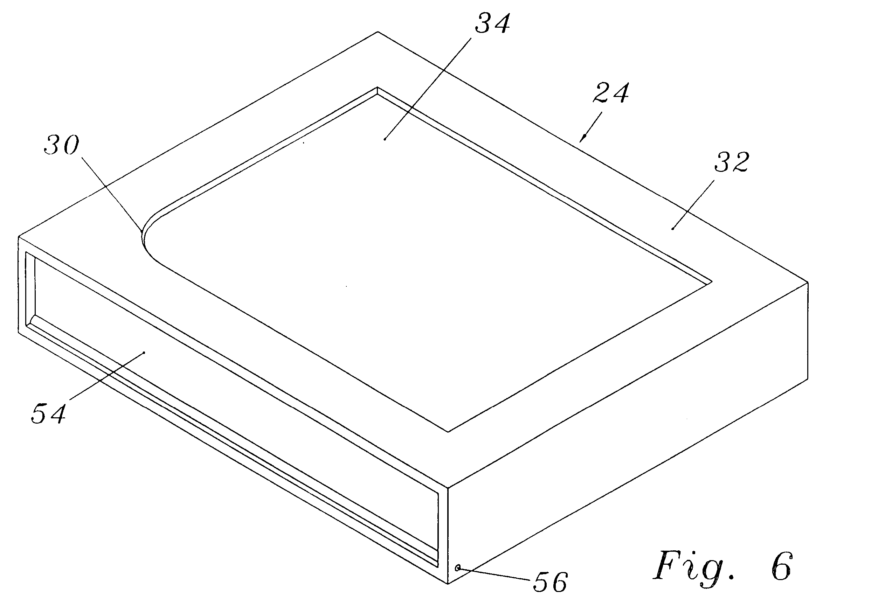

Wie die Figuren 5 und 6 zeigen, weisen die Kassetten 24 ein flaches quaderförmiges Kunststoffgehäuse auf. An der Unterseite 26 der Kassetten 24 ist eine nach außen vorspringende Erhebung 28 ausgebildet, die eine rechteckige Kontur mit einer abgerundeten Ecke 30 aufweist. In der Oberseite 32 der Kassette 24 ist eine zu der Erhebung 28 komplementäre Vertiefung 34 ausgebildet. Die Kontur der Vertiefung 34 entspricht der Kontur der Erhebung 28 der Unterseite, so daß die Kassetten 24 durch Eingreifen der Erhebung 28 in die Vertiefung 34 der darunterliegenden Kassette 24 formschlüssig aufeinandergestapelt werden können. Die abgerundete Ecke 30 der Erhebungen 28 und der Vertiefungen 34 gewährleistet dabei eine eindeutige unverdrehbare Zuordnung.

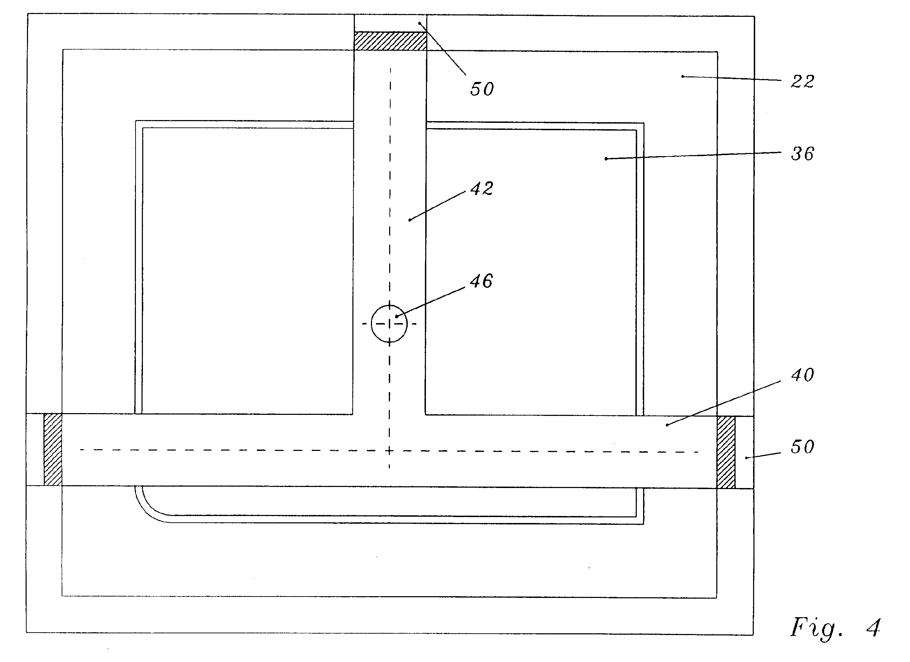

Wie Figur 4 zeigt, ist in der Oberfläche der Hubplatte 22 ebenfalls eine Vertiefung 36 vorgesehen, die der Vertiefung 34 in der Oberseite der Kassetten 24 in der Kontur entspricht. Dadurch können die Kassetten 24 in der gleichen Weise formschlüssig und positionsgenau auf der Hubplatte 22 gestapelt werden. Die Vertiefungen 34 und 36 sowie die Erhebung 28 sind an den Kanten jeweils abgeschrägt, um das Ineinanderfügen zu erleichtern.

Die Kassetten 24 können auf diese Weise unmittelbar auf der Hubplatte 22 aufgesetzt und gestapelt werden.

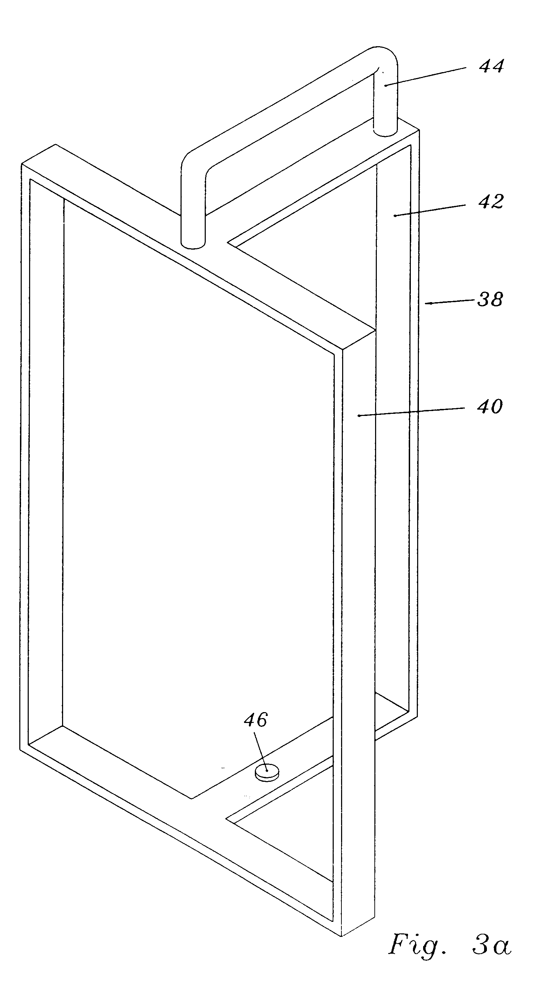

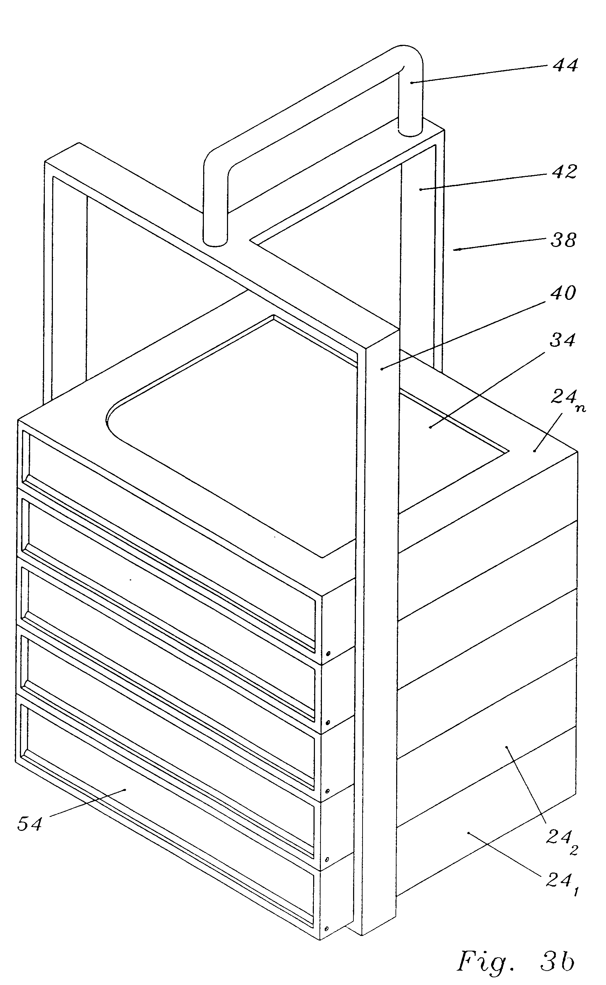

Weiter ist ein in den Figuren 3a und 3b dargestellter Kassettenträger 38 vorgesehen. Der Kassettenträger 38 besteht aus einem umlaufenden vertikalen Rahmen 40 und einem mittig senkrecht an diesem anschließenden vertikalen Rahmenteil 42. Dadurch ergibt sich eine in der Draufsicht T-förmige Konstruktion, in welche die Kassetten 24₁ bis 24ₙ gestapelt eingesetzt werden können, wobei sie durch den Rahmen 40 und das Rahmenteil 42 an drei Seiten gehalten werden, wie dies Figur 3b zeigt. Oben an dem Rahmenteil 42 ist ein Griffbügel 44 angebracht, so daß der Kassettenträger 38 von Hand erfaßt und getragen werden kann. Auf der unteren horizontalen Strebe des Rahmenteiles 42 ist mittig in dem Kassettenträger 38 ein nach oben ragender Zentriervorsprung 46 angeordnet. Die Kassetten 24 weisen, wie Figur 5 zeigt, in ihrer Unterseite 26 mittig eine Zentriervertiefung 48 auf. Beim Einsetzen des Kassettenstapels in den Kassettenträger 38 greift dessen Zentriervorsprung 46 in die Zentriervertiefung 48 der untersten Kassette 24₁ des Stapels ein, wodurch der gesamte Stapel in dem Kassettenträger 38 zentriert und gegen Verrutschen gesichert ist.

In die Oberfläche der Hubplatte 22 ist eine T-förmige Einfräsung 50 eingearbeitet, die mit der Form der unteren horizontalen Stege des Rahmens 40 und des Rahmenteiles 42 des Kassettenträgers 38 korrespondiert. Der Kassettenträger 38 mit dem eingesetzten Stapel der Kassetten 24₁ bis 24ₙ kann somit auf die Hubplatte 22 aufgesetzt werden, wobei die unteren Stege des Rahmens 40 und des Rahmenteiles 42 in die Einfräsung 50 eingreifen, so daß ihre Oberfläche mit der Oberfläche der Vertiefung 36 der Hubplatte 22 bündig ist. Die in dem Kassettenträger 38 aufgenommenen Kassetten 24 sitzen somit in exakt der gleichen Höhe und exakt gleich positioniert auf der Hubplatte 22 auf, unabhängig davon, ob die Kassetten 24₁ bis 24ₙ mit dem Kassettenträger 38 oder unmittelbar ohne den Kassettenträger 38 auf die Hubplatte 22 aufgesetzt werden.

Die Kassetten 24 nehmen jeweils ein Substrat 52 auf. In dem dargestellten Ausführungsbeispiel ist das Substrat 52 ein quadratisches Mehrschichtkeramiksubstrat. Die erfindungsgemäße Anordnung ist selbstverständlich auch für andere Substrate und andere Formen der Substrate verwendbar, wozu lediglich in für den Fachmann selbstverständlicher Weise die Aufnahme des Substrates 52 in der Kassette 24 der Form und den Abmessungen des Substrates angepaßt werden muß.

Das Gehäuse der Kassetten 24 ist allseitig geschlossen. Lediglich die Seitenwand der Kassetten 24, die bei dem orientierten Aufsetzen auf die Hubplatte 22 dem Beladeschlitz 12 zugewandt ist, ist offen und durch eine Verschlußklappe 54 verschließbar. Die Verschlußklappe 54 ist mittels Lagerzapfen 56 um ihre untere Kante verschwenkbar in dem Gehäuse der Kassette 24 gelagert. Die Verschlußklappe 54 ist etwas gegen die Kanten der Kassette 24 zurückgesetzt, um sie vor Beschädigung, Berührung und Kontamination zu schützen.

Im Inneren der Kassetten 24 ist eine Substratschublade 58 vorgesehen. Die Substratschublade 58 weist einen horizontal angeordneten U-förmigen Tragebügel 60 auf, der die gesamte Innenfläche der Kassette 24 einnimmt und gegen die Verschlußklappe 54 offen ist. An den beiden vorderen Enden des Tragebügels 60 ist jeweils ein parallel zur Verschlußklappe 54 nach außen gerichteter Querholm 62 angeformt. An den äußeren Enden der Querholme 62 ist jeweils eine Führungsstange 64 angebracht, die in einem der Länge der Querholme 62 entsprechenden Abstand parallel zu den Seitenschenkeln des Tragebügels 60 in das Innere der Kassette 24 hineinragt. Die Führungsstangen 64 sind jeweils mittels einer Kugelumlaufbuchse oder eines anderen geeigneten Linearführungselementes reibungsarm axial verschiebbar in einem Lagerbock 66 geführt. Beiderseits des Tragebügels 60 angeordnete Innentrennwände 68 des Kassettengehäuses trennen den den Tragebügel 60 aufnehmenden Kassettenraum von seitlichen Kammern 70, die die Führungsstangen 64 mit den Lagerböcken 66 aufnehmen. Die Innentrennwände 68 erstrecken sich jeweils durchgehend von der Unterseite 26 zur Oberseite 32 der Kassette und von der hinteren Seitenwand bis unmittelbar an die Verschlußklappe 54.

Zum Aus- und Einfahren der Substratschublade 58 greift an den Führungsstangen 64 ein Antriebsmechanismus an, der sich ebenfalls innerhalb der Kapselung des Hubwerkgehäuses befindet.

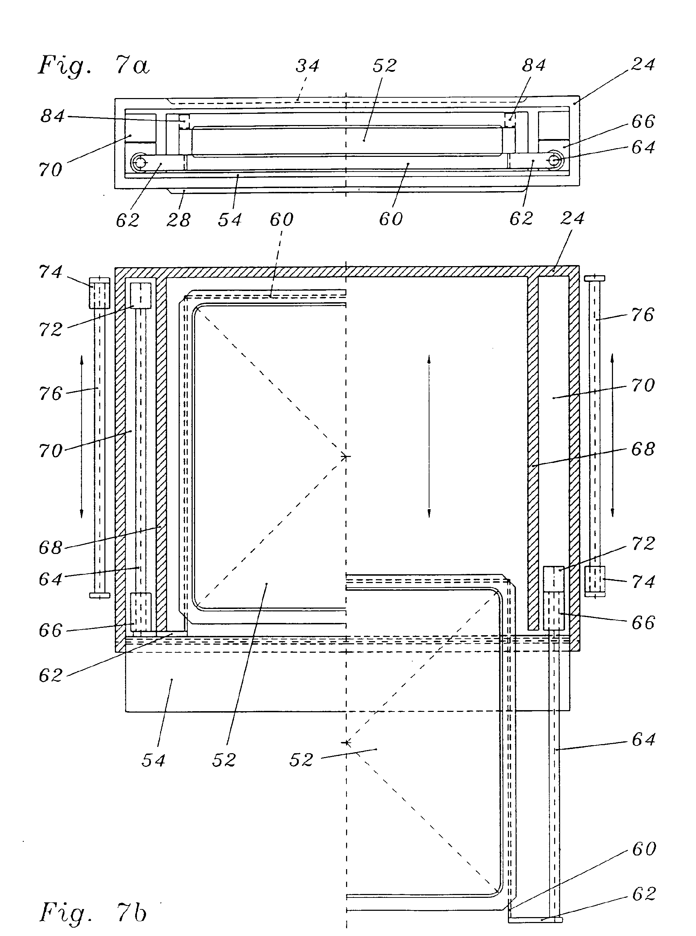

In dem Ausführungsbeispiel der Figuren 7a und 7b ist ein berührungsloser magnetischer Antriebsmechanismus vorgesehen. An dem freien hinteren Ende der Führungsstangen 64 ist ein Permanentmagnet 72 befestigt. Auf die Permanentmagneten 72 der Führungsstangen 64 wirken jeweils berührungslos durch die geschlossenen Seitenwände der Kassette 24 Magnete 74 ein, die auf Führungen 76 gesteuert angetrieben verschiebbar sind. Die Führungen 76 sind ortsfest vor dem Beladeschlitz 12 so in dem Hubwerk 18 angeordnet, daß sie sich beiderseits der vor dem Beladeschlitz 12 positionierten Kassette 24 befinden und parallel zu den Führungsstangen 64 verlaufen. Die Magnete 74 können Permanentmagnete oder Elektromagnete sein. Der Permanentmagnet 72 kann auch durch einen Körper aus ferromagnetischem Material ersetzt sein.

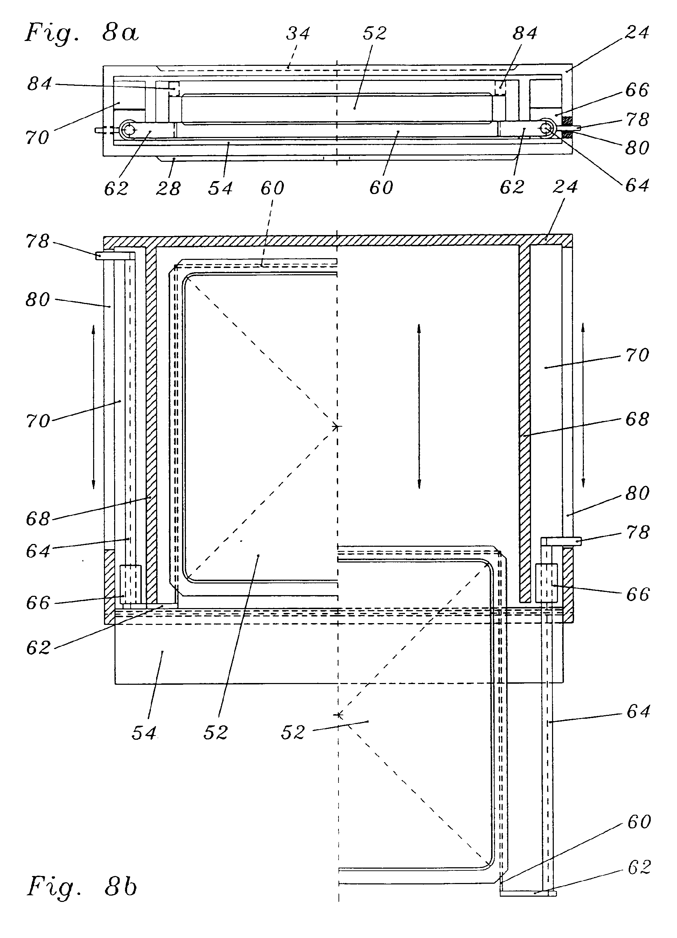

In einer in den Figuren 8a und 8b dargestellten anderen Ausführungsform ist an den freien hinteren Enden der Führungsstangen 64 jeweils ein Mitnehmer 78 angebracht, der seitlich durch einen Schlitz 80 der Seitenwand der Kassette 24 herausragt. In dem Hubwerk 18 sind beiderseits der vor dem Beladeschlitz 12 positionierten Kassette 24 nicht dargestellte mechanisch angetrieben verschiebbare Mitnahmeglieder angeordnet, die die Mitnehmer 78 erfassen, um die Substratschublade 58 ein- und auszuschieben.

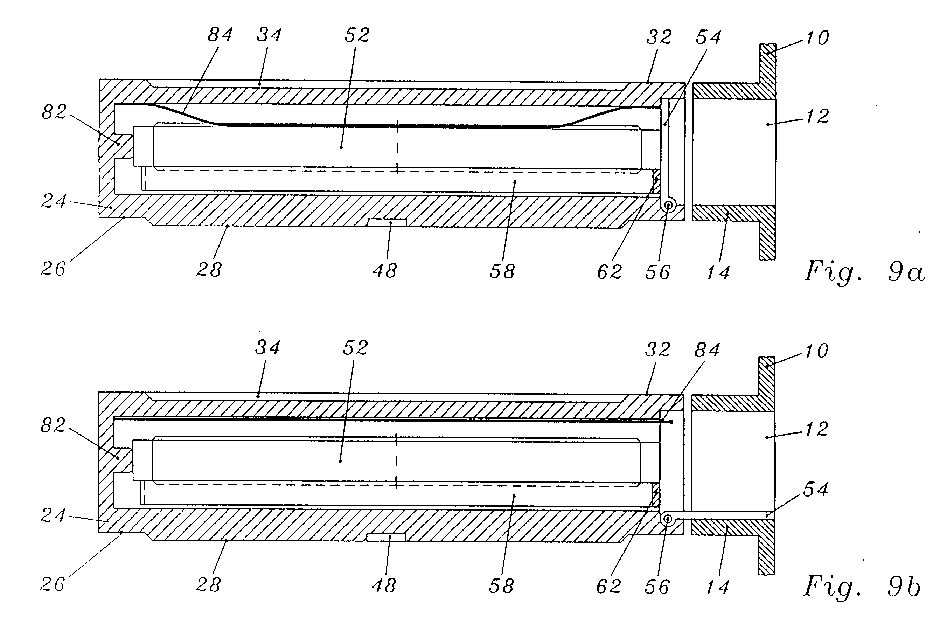

Das Substrat 52 liegt von oben in dem Tragebügel 60 der Substratschublade 58. Im dargestellten Ausführungsbeispiel eines Mehrschichtkeramiksubstrates liegt dieses mit seinem über die aktiven Oberflächen hinausragenden Rand auf dem Tragebügel 60 auf. Wird die Verschlußklappe 54 geschlossen, wie in Figur 9a gezeigt ist, so drückt die Verschlußklappe 54 gegen den vorderen Rand des Substrates 52 und drückt dieses nach hinten, so daß es mit seinem hinteren Rand gegen einen Anschlag 82 an der hinteren Seitenwand der Kassette 24 gedrückt wird. Auf den beiden Schenkeln des Tragebügels 60 können Begrenzungsstifte (-elemente) angebracht sein, die das Substrat seitlich in seiner Lage fixieren. Das Substrat 52 ist auf diese Weise in seiner Ebene unverschiebbar festgelegt. Innen an der Oberseite 32 der Kassette sind beidseitig Blattfedern 84 angebracht, die oberhalb und parallel zu den beiden Schenkeln des Tragebügels 60 verlaufen. Die beiden Blattfedern 84 sind jeweils mit ihrem hinteren, der Verschlußklappe 54 entgegengesetzten Ende an der Oberseite 32 der Kassette 24 festgelegt. Ihr vorderes Ende ist frei und ragt bei geöffneter Verschlußklappe 54 etwas nach vorn aus der Öffnung der Kassette 24 heraus, wie in Figur 9b gezeigt ist. Wird die Verschlußklappe 54 geschlossen, wie dies Figur 9a zeigt, so drückt die Verschlußklappe 54 axial gegen das überstehende Ende der Blattfedern 84, so daß diese sich federnd nach unten auswölben, wobei sie auf dem Rand des Substrates 52 zur Auflage kommen und diesen federnd gegen den Tragebügel 60 drücken.

Bei geschlossener Verschlußklappe ist das Substrat somit durch die Verschlußklappe 54 und den Anschlag 82 in seiner Ebene unverschiebbar und durch die Blattfedern 84 senkrecht zu seiner Ebene unbeweglich festgelegt. Die Kassette 24 kann auf diese Weise bei geschlossener Verschlußklappe 54 transportiert und gehandhabt werden, ohne daß die Gefahr einer Beschädigung oder Verschiebung des in der Kassette 24 aufgenommenen Substrates 52 besteht.

Der Funktionsablauf der Anordnung ist folgender:

Durch eine Bedienungsperson wird ein Stapel von Kassetten 24₁ bis 24ₙ entweder unmittelbar oder mittels des Kassettenträgers 38 auf die Hubplatte 22 des Hubwerkes 18 aufgesetzt, die sich zunächst in ihrer oberen in Figur 1 dargestellten Beladeposition befindet. Der Kassettenstapel wird dann von dem Hubwerk 18 getaktet nach unten bewegt, bis die unterste Kassette 24₁ vor dem Beladeschlitz positioniert ist, wie dies Figur 2 zeigt.

Die Verschlußklappe 54 der vor dem Beladeschlitz 12 positionierten Kassette 24 wird nun durch einen nicht dargestellten Mechanismus geöffnet, wobei sie nach unten in den Beladeschlitz 12 klappt und mit ihrer eventuell nicht reinen Außenseite innen auf der unteren Randlippe 14 des Beladeschlitzes 12 aufliegt. Eventuelle Kontaminationen der Außenseite der Verschlußklappe 54 sind somit zwischen der Verschlußklappe 54 und der Randlippe 14 eingeschlossen und können das Substrat nicht kontaminieren. Der aus dem Reinraum durch den Beladeschlitz 12 austretende Reinluftstrom 16 strömt durch die Fuge zwischen der Kassette 24 und den Randlippen 14 nach außen und verhindert ein Eindringen von Staubpartikeln in die Kassette 24. Mittels des beiderseits angeordneten Antriebsmechanismus wird die Substratschublade 58 nun aus der Kassette 24 herausgeschoben, wie dies in Figur 2 gestrichelt und in den Figuren 7b und 8b in der rechten Hälfte dargestellt ist. Das Substrat 52 kann nun durch eine Handlingseinrichtung aus der Substratschublade 58 entnommen und dem Behandlungsvorgang zugeführt werden.

Nach Abschluß des Behandlungsvorganges wird das Substrat 52 in umgekehrter Reihenfolge wieder in die Substratschublade 58 eingesetzt und diese wird wieder in die Kassette 24 zurückgefahren, wie dies in den Figuren 7b und 8b in der linken Hälfte dargestellt ist.

Abriebspartikel, die durch die Führung der Führungsstangen 64 in den Lagerböcken 66 entstehen können, werden durch die Innentrennwände 68 von dem das Substrat 52 aufnehmenden Kassettenraum ferngehalten. Bei geöffneter Verschlußklappe 54 verhindert der durch den Beladeschlitz 12 austretende Reinluftstrom 16, daß irgendwelche Abriebspartikel aus den seitlichen Kammern 70 über deren vordere Öffnung austreten und an das Substrat 52 gelangen. Bei der Ausführungsform der Figuren 8a und b verhindert der Reinluftstrom 16 auch ein Eindringen von Schmutzpartikeln durch die seitlichen Schlitze 80 der Kassettenwand. Ist die Verschlußklappe 54 geschlossen, so liegt sie an der vorderen Stirnkante der Innentrennwände 68 an und verschließt somit die seitlichen Kammern 70 gegen den das Substrat 52 aufnehmenden Kassettenraum.

Die im Hubwerk 18 gestapelten Kassetten 24₁ bis 24ₙ können aufeinanderfolgend abgearbeitet werden, wobei die Substrate 52 jeweils derselben Behandlung unterworfen werden. Es ist auch ein automatisch gesteuertes Abarbeiten in beliebiger Reihenfolge und mit verschiedenen Behandlungsprozessen möglich. Eine besonders hohe Flexibilität wird dadurch begünstigt, daß in der der Verschlußklappe 54 gegenüberliegenden Seitenwand der Kassette 24 ein durchsichtiges Fenster 86 vorgesehen ist, wie Figur 5 zeigt. Durch dieses Fenster kann optisch eine am Rand des Substrates 52 angebrachte Kennzeichnung abgetastet werden, die in Steuerbefehle für die Behandlung des Substrates 52 und für den Transport und die Lagerung der das Substrat 52 aufnehmenden Kassette 24 umgewandelt wird.

## Patentansprüche

1. Anordnung zum Lagern und Transportieren von Substraten unter Reinraumbedingungen und zum Einschleusen der Substrate in einen Reinraum mit einem in der äußeren Trennwand (10) des Reinraumes vorgesehenen Beladeschlitz (12), wobei jeweils ein einzelnes Substrat aufnehmende verschließbare Kassetten (24) vorhanden sind,
dadurch gekennzeichnet,
daß die Kassetten (24) in einer Seitenwand eine Verschlußklappe (54) aufweisen, daß die Kassetten (24) eine durch die geöffnete Verschlußklappe (54) ausfahrbare, das Substrat (52) tragende Substratschublade (58) aufweisen, daß die Kassetten (24) mit ihrer Verschlußklappe (54) in Ausrichtung zu dem Beladeschlitz (12) positionierbar sind und daß Mechanismen zum Öffnen der Verschlußklappe (54) und zum Ausfahren der Substratschublade (58) vor dem Beladeschlitz (12) angeordnet sind.

2. Anordnung nach Anspruch 1, dadurch gekennzeichnet, daß der Beladeschlitz (12) nach außen gegen die positionierte Kassette (24) vorspringende Randlippen (14) aufweist.

3. Anordnung nach den Ansprüchen 1 und 2, dadurch gekennzeichnet, daß sich die Verschlußklappe (54) um eine ihrer Längskanten schwenkend nach außen öffnet und sich in ihrer Offenstellung auf die Innenfläche einer Randlippe (14) des Beladeschlitzes (12) auflegt.

4. Anordnung nach wenigstens einem der vorhergehenden Ansprüche, dadurch gekennzeichnet, daß außerhalb der Trennwand (10) des Reinraumes vor dem Beladeschlitz (12) ein Hubwerk (18) angeordnet ist, das mehrere Kassetten (24) gestapelt aufnimmt und nacheinander an dem Beladeschlitz (12) positioniert, und daß das Hubwerk (18) durch ein Gehäuse gekapselt ist und daß sich der Beladeschlitz (12) und die Mechanismen zum Öffnen der Verschlußklappe (54) und zum Ausfahren der Substratschublade (58) innerhalb dieses Gehäuses befinden.

5. Anordnung nach wenigstens einem der vorhergehenden Ansprüche, dadurch gekennzeichnet, daß die Kassetten (24) zum formschlüssigen Stapeln in ihrer Oberseite (32) und ihrer Unterseite (26) jeweils zueinander komplementäre Vertiefungen (34) bzw. Erhebungen (28) aufweisen.

6. Anordnung nach den Ansprüchen 4 und 5, dadurch gekennzeichnet, daß das Hubwerk (18) eine Hubplatte (22) aufweist, deren Oberfläche eine zu den Vertiefungen bzw. Erhebungen (28) der Unterseite (26) der Kassetten (24) komplementäre Erhebung oder Vertiefung (36) aufweist.

7. Anordnung nach wenigstens einem der Ansprüche 4 bis 6, dadurch gekennzeichnet, daß mehrere Kassetten (24) in einem Kassettenträger (38) stapelbar sind, der auf das Hubwerk (18) aufsetzbar ist.

8. Anordnung nach Anspruch 7, dadurch gekennzeichnet, daß der Kassettenträger (38) in eine Einfräsung (50) der Oberfläche der Hubplatte (22) des Hubwerkes (18) einsetzbar ist, so daß die Kassetten (24) in dem auf die Hubplatte (22) aufgesetzten Kassettenträger (38) dieselbe Lage einnehmen wie unmittelbar auf die Hubplatte (22) aufgesetzte Kassetten (24).

9. Anordnung nach wenigstens einem der vorhergehenden Ansprüche, dadurch gekennzeichnet, daß die Substratschublade (58) einen U-förmigen gegen die Verschlußklappe (54) offenen Tragebügel (60) aufweist, der das Substrat (52) trägt.

10. Anordnung nach wenigstens einem der vorhergehenden Ansprüche, dadurch gekennzeichnet, daß die Substratschublade (58) beidseitig in Ausfahrrichtung geführt verschiebbare Antriebsglieder aufweist, an denen der Mechanismus zum Ausfahren angreift, wobei vorzugsweise die Antriebsglieder jeweils in einer seitlichen Kammer (70) der Kassette (24) angeordnet sind, die durch eine Innentrennwand (68) von dem das Substrat (52) aufnehmenden Raum der Kassette (24) abgetrennt ist.

## Claims

1. Arrangement for storing and transporting substrates under clean room conditions and for loading the substrates into a clean room with the outer partition (10) of the clean room having a loading slot (12), wherein sealable cassettes (24) each accommodating one substrate are provided,
characterized in
that the cassettes (24) have a sealing flap (54) in one side wall, that the cassettes (24) are provided with a substrate drawer (58) which supports the substrate (52) and can be moved out through the opened sealing flap (54), that the cassettes (24) with their sealing flap (54) are alignable to the loading slot (12), and that there are mechanisms for opening the sealing flap (54) and for moving the substrate drawer (58) to a position external to the loading slot (12).

2. Arrangement according to claim 1, characterized in that the loading slot (12) has lips (14) projecting towards the outside in the direction of the positioned cassette (24).

3. Arrangement according to claims 1 and 2, characterized in that the sealing flap (54) by pivoting about one of its longitudinal edges opens towards the outside, resting in its open position on the inner surface of one lip (14) of the loading slot (12).

4. Arrangement according to at least one of the preceding claims, characterized in that outside the partition (10) of the clean room external to the loading slot (12) a lifting means (18) is arranged which accommodates several stacked cassettes (24) and successively positions them at the loading slot (12), and that the lifting means (18) is enclosed in a housing, and that the loading slot (12) and the mechanisms for opening the sealing flap (54) and for moving out the substrate drawer (58) are positioned inside said housing.

5. Arrangement according to at least one of the preceding claims, characterized in that the cassettes (24) on their top side (32) and their bottom side (26) are formed with complementary indentations (34) and protrusions (28) for positive stacking.

6. Arrangement according to claims 4 and 5, characterized in that that the lifting means (18) has a lifting plate (22), the surface of which is provided with a protrusion or an indentation (36) complementary to the indentations or protrusions (28) on the bottom side (26) of the cassettes (24).

7. Arrangement according to at least one of the claims 4 to 6, characterized in that several cassettes (24) are stackable in a cassette carrier (38) which may be placed on the lifting means (18).

8. Arrangement according to claim 7, characterized in that the cassette carrier (38) is insertable into a milled recess (50) in the top surface of the lifting plate (22) of the lifting means (18) so that the cassettes (24) in the cassette carrier (38) placed on the lifting plate (22) assume the same position as the cassettes (24) placed directly on the lifting plate (22).

9. Arrangement according to at least one of the preceding claims, characterized in that the substrate drawer (58) has a U-shaped support bracket (60) which is open in the direction of the sealing flap (54) and which supports the substrate (52).

10. Arrangement according to at least one of the preceding claims, characterized in that the substrate drawer (58) comprises on either side actuators guided and movable in the direction in which drawer (58) is moved out, said actuators being engaged by the move-out mechanism and being preferably arranged in a lateral chamber (70) of the cassette (24), which is separated by an inner partition (68) from the space of the cassette (24) accommodating the substrate (52).

## Revendications

1. Agencement destiné au stockage et au transport de substrats dans des conditions de salle blanche et à l'éclusage des substrats dans une salle blanche, avec une fente de chargement (12) prévue dans la cloison extérieure (10) de la salle blanche, en présence de cassettes (24) verrouillables destinées à recevoir chacune un seul substrat,
caractérisé en ce que
les cassettes (24) présentent un clapet (54) sur l'une des parois latérales, que les cassettes (24) présentent un tiroir à substrats (58) supportant le substrat (52) et pouvant être déployé au travers du clapet ouvert (54), que les cassettes (24) sont positionnables avec leur clapet (54) par rapport à la fente de chargement (12) et que le mécanisme d'ouverture du clapet (54) et de déploiement du tiroir à substrats (58) est agencé devant la fente de chargement (12).

2. Agencement selon la revendication 1, caractérisé en ce que la fente de chargement (12) présente des lèvres (14) en saillie vers l'extérieur, contre la cassette (24) positionnée.

3. Agencement selon les revendications 1 et 2, caractérisé en ce que le clapet (54) s'ouvre vers l'extérieur en pivotant autour de l'un des bords longitudinaux et qu'il vient s'appuyer en position ouverte sur la surface intérieure d'une lèvre (14) de la fente de chargement (12).

4. Agencement selon au moins une des revendications précédentes, caractérisé en ce qu'un dispositif de levage (18) est agencé à l'extérieur de la cloison (10) de la salle blanche, devant la fente de chargement (12), et qu'il reçoit plusieurs cassettes (24) empilées et qu'il les positionne l'une après l'autre sur la fente de chargement (12) et que le dispositif de levage (18) est entièrement fermé par un carter et que la fente de chargement (12) et les mécanismes d'ouverture du clapet (54) et de déploiement du tiroir à substrats (58) se trouvent à l'intérieur de ce carter.

5. Agencement selon au moins une des revendications précédentes, caractérisé en ce que les cassettes (24) présentent des enfoncements (34) et des soulèvements (28) complémentaires dans leur face supérieure (32) et inférieure (26) destinés à un empilage positif.

6. Agencement selon les revendications 4 et 5, caractérisé en ce que le dispositif de levage (18) présente un plateau de levage (22), dont la surface présente un soulèvement ou un enfoncement (36) complémentaire aux enfoncements ou soulèvements (28) de la face inférieure (26) des cassettes (24).

7. Agencement selon au moins une des revendications 4 à 6, caractérisé en ce que plusieurs cassettes (24) sont empilables dans un support de cassettes (38) qui peut être logé sur le dispositif de levage (18).

8. Agencement selon la revendication 7, caractérisé en ce que le support de cassettes (38) peut être logé dans une rainure (50) fraisée à la surface du plateau de levage (22) du dispositif de levage (18), de sorte que les cassettes (24) du support de cassettes (38) disposé sur le plateau de levage (22) adoptent la même position que les cassettes (24) directement déposées sur le plateau de levage (22).

9. Agencement selon au moins une des revendications précédentes, caractérisé en ce que le tiroir à substrats (58) présente une poignée (60) en U ouverte contre le clapet (54), qui porte le substrat (52).

10. Agencement selon au moins une des revendications précédentes, caractérisé en ce que le tiroir à substrats (58) présente des éléments moteur mobiles de part et d'autre dans le sens du déploiement, sur lesquels le mécanisme destiné au déploiement vient s'engrener, les éléments moteurs étant de préférence agencés dans une chambre latérale (70) des cassettes (24), qui est séparée de l'espace des cassettes (24) destiné à recevoir le substrat (52), par une cloison intérieure (68).
